# EUROPEAN PATENT APPLICATION

(11) **EP 4 738 710 A1**
(43) Date of publication of application: **06.05.2026**
(21) Application number: 25211976.3
(22) Date of filing: 29.10.2025
(51) Int. Cl.: H03M 1/10

(54) **SYSTEMS AND METHODS FOR SIGNAL-TO-NOISE RATIO (SNR) OPTIMIZATION USING BIAS CONTROL**

(30) Priority: 31.10.2024 US 202418933369
(71) Applicant: Avago Technologies International Sales Pte. Limited, Singapore 768923 (SG)
(72) Inventor: Jara Toro, Matias Ignacio, Irvine, 92618 (US); Khanpour, Mehdi, Irvine, 92612 (US); Vakilian, Kambiz, Irvine, 92603 (US)
(74) Representative: Dilg, Haeusler, Schindelmann Patentanwaltsgesellschaft mbH

(57) **Abstract**

The subject technology is directed to an apparatus for signal processing. In an embodiment, the apparatus includes a driver configured to receive an input signal comprising a first signal component characterized by a first voltage level and a second signal component characterized by a second voltage level. The apparatus further includes a first circuit configured to adjust the first voltage level by applying a first bias voltage to the first signal component and adjust the second voltage level by applying a second bias voltage to the second signal component. A quantizer is coupled to the driver and configured to generate an output signal based at least on the first voltage level and the second voltage level. This configuration allows for improved signal-to-noise ratio and effective use of the quantizer's dynamic range, enhancing the clarity and accuracy of signal processing in differential systems. There are other embodiments as well.

## Description

### BACKGROUND OF THE INVENTION

Light detection and ranging (LiDAR) systems and optical time-of-flight (ToF) systems are widely used for distance measurement and object detection in various applications such as automotive, robotics, and industrial automation. These systems operate by emitting a pulse of light (e.g., a laser pulse) and measuring the time it takes for the pulse to reflect off a target and return to a detector. High precision and signal clarity are important for accurate distance measurement, particularly in applications where high-resolution mapping is required.

In LiDAR and optical ToF systems, the reflected signal from a target may be captured by a photodetector (e.g., a photodiode), which converts the light into an electrical signal. The electrical signal is then processed by a series of circuit components, such as amplifiers and analog-to-digital converters (ADCs), to create a digital representation of the signal. Achieving accurate distance measurements depends on a high signal-to-noise ratio (SNR), which ensures that the signal can be clearly distinguished from any surrounding noise. However, due to factors such as ambient light, sensor noise, and limited ADC dynamic range, maintaining high SNR in these systems can be challenging, often resulting in compromised signal clarity and reduced accuracy in distance measurements.

Various approaches for improving SNR in LiDAR and ToF systems have been explored, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a schematic diagram illustrating a front-end signal processing system, in accordance with various embodiments of the subject technology.
Figure 2 is a schematic diagram illustrating the signal input and output of an analog-to-digital converter (ADC), in accordance with various embodiments of the subject technology.
Figure 3 is a schematic diagram illustrating the signal input and output of an analog-to-digital converter (ADC), in accordance with various embodiments of the subject technology.
Figure 4A is a schematic diagram illustrating a driver circuit with a bias control mechanism, in accordance with various embodiments of the subject technology.
Figure 4B is a schematic diagram illustrating the signal input of an analog-to-digital converter (ADC), in accordance with various embodiments of the subject technology.
Figure 5 is a schematic diagram illustrating a driver circuit with a bias control mechanism, in accordance with various embodiments of the subject technology.

### DETAILED DESCRIPTION OF THE INVENTION

The subject technology is directed to an apparatus for signal processing. In an embodiment, the apparatus includes a driver configured to receive an input signal comprising a first signal component characterized by a first voltage level and a second signal component characterized by a second voltage level. The apparatus further includes a first circuit configured to adjust the first voltage level by applying a first bias voltage to the first signal component and adjust the second voltage level by applying a second bias voltage to the second signal component. A quantizer is coupled to the driver and configured to generate an output signal based at least on the first voltage level and the second voltage level. This configuration allows for improved signal-to-noise ratio and effective use of the quantizer's dynamic range, enhancing the clarity and accuracy of signal processing in differential systems. There are other embodiments as well.

One general aspect includes an apparatus, which comprises a driver configured to receive an input signal, the input signal comprising a first signal component and a second signal component. The first signal component is characterized by a first voltage level and a first polarity. The second signal component is characterized by a second voltage level and a second polarity, the first polarity being opposite the second polarity. The apparatus further comprises a first circuit coupled to the driver. The first circuit is configured to adjust a first voltage level by applying a first bias voltage to the first signal component and adjust a second voltage level by applying a second bias voltage to the second signal component. The apparatus further comprises a quantizer coupled to the driver. The quantizer is configured to generate an output signal based at least on the first voltage level and the second voltage level.

Implementations may include one or more of the following features. The apparatus further comprises a controller coupled to the first circuit, the controller is configured to adjust the first bias voltage and the second bias voltage based at least on the output signal. The controller is configured to store a plurality of bias voltage profiles comprising the first bias voltage and the second bias voltage. The first circuit is further configured to calibrate the first bias voltage and the second bias voltage based on a reference signal. The first circuit is coupled to the driver through a first node and a second node, the first node is associated with the first signal component, and the second node is associated with the second signal component. The quantizer comprises a sampling circuit configured to sample the input signal based on a predetermined interval. The first circuit comprises a second circuit configured to receive a first reference voltage and generate the first bias voltage based on the first reference voltage. The first circuit comprises a third circuit configured to receive a second reference voltage and generate the second bias voltage based on the second reference voltage. The output signal is associated with a difference between the first voltage level and the second voltage level. The output signal comprises a digital signal. The first bias voltage is configured to increase the first voltage level and the second bias voltage is configured to decrease the second voltage level.

According to another embodiment, the subject technology provides an apparatus, which comprises a driver configured to receive an input signal, the input signal comprising a first signal component and a second signal component, the first signal component being characterized by a first voltage level, the second signal component being characterized by a second voltage level. The apparatus further comprises a first circuit coupled to the driver, the first circuit is configured to adjust a first voltage level by applying a first bias voltage to the first signal component and adjust a second voltage level by applying a second bias voltage to the second signal component. The apparatus further comprises a quantizer coupled to the driver, the quantizer being configured to generate an output signal based at least on the first voltage level and the second voltage level.

Implementations may include one or more of the following features. The apparatus further comprises a controller coupled to the first circuit, the controller being configured to adjust the first bias voltage and the second bias voltage based at least on the output signal. The first bias voltage is configured to increase the first voltage level. The second bias voltage is configured to decrease the second voltage level. The first circuit is coupled to the driver through a first node and a second node, the first node is associated with the first signal component, and the second node is associated with the second signal component. The output signal is associated with a difference between the first voltage level and the second voltage level.

According to yet another embodiment, the subject technology provides an apparatus, which comprises a driver configured to receive an input signal, the input signal comprising a first signal component and a second signal component, the first signal component being characterized by a first voltage level, the second signal component being characterized by a second voltage level. The apparatus further comprises a first circuit coupled to the driver, the first circuit comprising a second circuit configured to generate a first bias voltage and a third circuit configured to generate a second bias voltage, the first circuit being configured to adjust the first voltage level by applying the first bias voltage to the first signal component and adjust the second voltage level by applying the second bias voltage to the second signal component. The apparatus further comprises a quantizer coupled to the driver, the quantizer being configured to generate an output signal based at least on the first voltage level and the second voltage level. In various embodiments, the apparatus further comprises a controller coupled to the first circuit, the controller is configured to adjust the first bias voltage and the second bias voltage based at least on the output signal.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent, or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

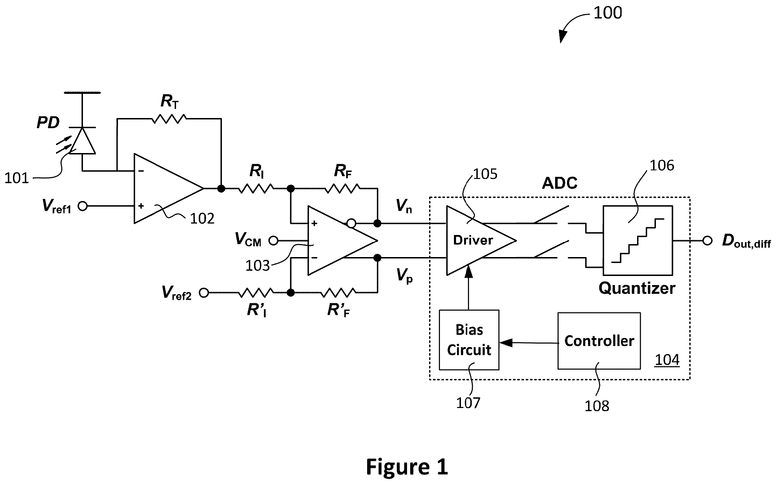

Figure 1 is a schematic diagram illustrating a front-end signal processing system 100, in accordance with various embodiments of the subject technology. This diagram merely provides an example, which should not unduly limit the scope of the claims. One of ordinary skill in the art would recognize many variations, alternatives, and modifications.

In various implementations, system 100 may be part of a sensor-based system designed to receive, process, and/or interpret signals generated by various types of sensors and may be used in various applications such as medical imaging, industrial monitoring, environmental sensing, or telecommunications. For instance, system 100 can be utilized in applications such as LiDAR, ToF measurement systems, autonomous vehicle navigation systems, and augmented reality (AR) devices to interpret spatial data and enable precise object detection or distance measurement.

As shown, system 100 includes photodiode 101. For instance, the term "photodiode" may refer to a device that detects light and converts it into an electrical signal. Examples of photodiodes may include, without limitation, PIN photodiodes, PN photodiodes, avalanche photodiodes (APDs), silicon photodiodes, and/or the like. In some examples, photodiode 101 may be configured to detect incoming photons and convert the resulting energy into an electrical current signal that is proportional to the photon flux. In various examples, the output signal of photodiode 101 may include a unipolar pulsed signal. For example, a unipolar pulsed signal may refer to an electrical signal that swings in only one polarity (e.g., positive or negative) relative to a reference baseline.

In some implementations, system 100 may include transimpedance amplifier (TIA) 102, which may be coupled to photodiode 101. For example, the term "transimpedance amplifier" may refer to an electronic device that converts input current to a corresponding output voltage. Examples of TIAs may include, without limitation, photodiode TIAs, low-noise TIAs, programmable gain TIAs, and/or the like. TIA 102 may be configured to convert a current signal generated by photodiode 101 into a voltage signal. The voltage signal may be proportional to the current signal generated by photodiode 101 and represent the photon flux or other physical phenomena being measured. In some examples, TIA 102 is configured with resistor R_{T}. which sets the gain of TIA 102 by determinine the relationship between the input current from photodiode 101 and the output voltage. In some cases, V_{ref1} may be applied as a reference voltage input to TIA 102, providing a baseline for its output signal.

According to some embodiments, system 100 further includes amplifier 103, which may be coupled to TIA 102. For example, the term "amplifier" may refer to a device or circuit that increases the magnitude of an input signal. Examples of amplifiers may include operational amplifiers (op-amps), differential amplifiers, power amplifiers, and/or the like. In some examples, amplifier 103 may include a differential amplifier, which receives the output signal from TIA 102 and converts it into a differential signal.

In some examples, amplifier 103 receives the voltage output from TIA 102 through resistor R_{I}, and it operates with reference voltages V_{ref2} and V_{CM}. For instance, amplifier 103 receives reference voltage V_{ref2} through resistor R_{I}'. V_{ref2} sets a baseline voltage for the input of amplifier 103, and V_{CM} establishes a stable common-mode voltage for the amplifier's differential output. In various implementations, the amplifier's output produces two complementary signals, Vₚ and Vₙ, which represent the positive and negative components of the differential signal, respectively. These signals may be characterized by opposite polarities, enhancing the system's noise rejection capabilities. In some cases, resistors R_{F} and R_{F}' are connected in a feedback loop within amplifier 103, maintaining consistent gain and providing stability to the amplified differential signal.

In various implementations, system 100 further includes analog-to-digital converter (ADC) 104. For example, the term "analog-to-digital converter" may refer to an electronic device that converts an analog input signal into a corresponding digital output. Examples of ADCs may include, without limitation, successive approximation ADCs, delta-sigma ADCs, flash ADCs, and/or the like. In some examples, the input to ADC 104 may include a differential signal composed of the complementary signals (e.g., Vₚ and Vₙ). ADC 104 may be configured to receive these differential inputs and convert them into a digital signal (e.g., D_{out,diff}), which represents the amplitude of the original analog signal as a discrete digital value. This digital representation allows system 100 to perform further processing and analysis of the signal in digital form, which is useful for applications requiring high precision and reliable data interpretation, such as LiDAR and ToF measurements.

In some embodiments, ADC 104 includes driver 105. For example, the term "driver" may refer to an electronic circuit or amplifier stage that conditions and delivers the input signal to subsequent stages of a device. Depending on the implementation, driver 105 may amplify the input signal, buffer the signal to prevent loading effects, filter highfrequency noise, or provide impedance matching between different circuit stages. Examples of drivers may include, without limitation, buffer amplifiers, voltage followers, line drivers, and/or the like.

In various examples, driver 105 is configured to receive an input signal (e.g., from amplifier 103), which may include differential signals (e.g., Vₚ and Vₙ). For instance, the input signal may include a first signal component (e.g., Vₚ) and a second signal component (e.g., Vₙ). The first and second signal components may be complementary, meaning they represent two parts of a differential pair where one signal is the inverse or opposite of the other.

For instance, the first signal component may be characterized by a first polarity and the second signal component may be characterized by a second polarity. The first polarity may be opposite the second polarity. For example, the term "polarity" may refer to the direction of a voltage or current relative to a reference point, such as a ground or common-mode voltage. In some examples, polarity indicates whether a signal component represents a positive or negative deviation from the reference point (e.g., common-mode voltage).

In some cases, the first signal may be characterized by a first voltage level and the second signal may be characterized by a second voltage level. For instance, the term "voltage level" may refer to the magnitude or potential difference of an electrical signal relative to a reference point, such as ground or a common-mode voltage. Voltage level may indicate how much the signal deviates from the baseline or zero point, which in turn determines the strength or amplitude of the signal.

In some embodiments, ADC 104 further includes quantizer 106, which may be coupled to driver 105. For instance, the term "quantizer" may refer to a component that converts a continuous analog signal into a discrete digital representation. Examples of quantizers may include, without limitation, flash quantizers, successive approximation quantizers, delta-sigma quantizers, and/or the like.

In various examples, quantizer 106 receives the conditioned signals from driver 105 and converts them into a digital output signal (e.g., D_{out,diff}). During this process, the quantizer samples the input signals and assigns digital codes based on their voltage levels, effectively mapping the continuous variations of the analog input into discrete steps. The digital output may then be used for further analysis and processing by system 100, enabling precise interpretation of the original analog signal. For instance, quantizer 106 may include a sampling circuit configured to sample the input signal based on a predetermined interval. The term "sampling circuit" may refer to an electronic circuit that extracts discrete samples from a continuous analog signal at regular intervals. It allows quantizer 106 to convert a continuous-time signal into a discrete-time signal. Examples of sampling circuits may include, without limitation, sample-and-hold circuits, clocked comparators, and/or the like.

As previously noted, the output signal of photodiode 101 may include a unipolar pulsed signal, meaning that it varies in only one direction relative to a baseline voltage. However, this unipolar nature poses challenges when interfacing with ADC 104, which is designed to accept differential input signals for optimal performance. A unipolar signal only utilizes half of the ADC's input range, resulting in inefficient use of the dynamic range and a reduced SNR. Because only one-half of the ADC's range is used, the effective resolution of the ADC is decreased, as the system cannot take advantage of the full range of input levels to distinguish finer differences in signal amplitude. For example, using only half of the ADC's input range may cause a 6 dB reduction in SNR, which corresponds to the loss of one bit of resolution, meaning an 8-bit ADC would function with the performance equivalent of a 7-bit ADC.

In various implementations, ADC 104 may implement a bias control mechanism to introduce an offset to the input signal, allowing the ADC to make full use of its dynamic range. For example, the term "offset" may refer to an adjustment or shift in the baseline level of an input signal. This adjustment modifies the reference point from which the signal varies, effectively shifting the entire signal up or down relative to the baseline (e.g., a common-mode voltage or ground).

As an example, ADC 104 includes circuit 107, which may be coupled to driver 105. Circuit 107 may be configured to adjust the bias voltages applied to the input signal (e.g., the first and second signal components), thereby introducing an offset that shifts the baseline of the differential input signal. For instance, the term "bias voltage" may refer to a steady voltage applied to an electronic circuit to establish a desired operating point or baseline level for a signal.

Depending on the implementation, the bias voltages may include a positive bias voltage applied to raise the baseline of a signal component, or a negative bias voltage applied to lower the baseline. In some examples, bias voltages may also be programmable, allowing for dynamic adjustments in response to changes in the input signal or operating conditions. For instance, circuit 107 may apply separate bias voltages to the positive (e.g., Vₚ) and negative (e.g., Vₙ) components of a differential signal to introduce a controlled offset, ensuring that they are centered within the ADC's input range. This centering allows the ADC to utilize its full dynamic range, improving the effective SNR and overall precision of the analog-to-digital conversion.

As an example, circuit 107 may be configured to adjust the first voltage level by applying a first bias voltage to the first signal component and adjust the second voltage level by applying a second bias voltage to the second signal component. In some cases, quantizer 106 may be configured to generate the output signal (e.g., D_{out,diff}) based at least on the first voltage level and the second voltage level. The output signal may be associated with a difference between the first voltage level and the second voltage level. In various examples, the first bias voltage may be configured to increase the first voltage level and the second bias voltage may be configured to decrease the second voltage level.

In various implementations, ADC 104 further includes controller 108, which may be coupled to circuit 107. For example, the term "controller" may refer to an electronic component or processing unit that manages the operation of other circuits. Examples of controllers may include, without limitation, microcontrollers, digital signal processors (DSPs), programmable logic controllers (PLC), and/or the like. In some examples, controller 108 may determine and adjust the bias voltages applied by circuit 107 based on various factors, such as the characteristics of the input signal received from photodiode 101 or the digital output signal produced by ADC 104. For example, controller 108 may be configured to adjust the first bias voltage and the second bias voltage based on the output signal (e.g., D_{out,diff}). By monitoring these signals, controller 108 can make real-time adjustments to ensure that the differential input signal is centered within the ADC's input range.

In some implementations, controller 108 may be configured to store predefined settings in the form of a lookup table or other memory structures. For instance, controller 108 is configured to store a plurality of bias voltage profiles comprising the first bias voltage and the second bias voltage. These settings may correspond to different operating conditions, such as temperature variations, input signal levels, or specific measurement requirements. By referencing the lookup table, controller 108 can quickly adjust the bias voltages to a suitable preset value based on detected conditions, ensuring consistent performance of ADC 104 without needing to perform continuous real-time calculations.

According to various embodiments, circuit 107 may be configured to calibrate the first bias voltage and the second bias voltage based on a reference signal. Calibration ensures that the bias voltages are optimized to maintain the desired offset and signal range, allowing system 100 to adapt to varying input conditions and achieve accurate analog-to-digital conversion. In some examples, the reference signal may serve as a stable baseline that circuit 107 uses to adjust the bias voltages, aligning the input signal with the range of ADC 104 and compensating for any drift or deviations that may occur due to temperature changes, component aging, or other environmental factors.

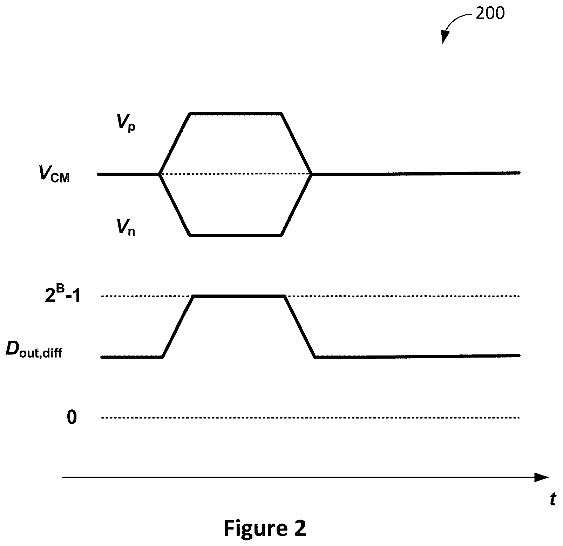

Figure 2 is a schematic diagram illustrating the signal input and output of an ADC 200, in accordance with various embodiments of the subject technology. This diagram merely provides an example, which should not unduly limit the scope of the claims. One of ordinary skill in the art would recognize many variations, alternatives, and modifications.

In various implementations, ADC 200 may be part of a larger sensor-based or signal-processing system, such as ADC 104 depicted in Figure 1. In these systems, ADC 200 may be used to convert analog signals into digital representations for further analysis, processing, and interpretation. For instance, ADC 200 may be used in applications such as LiDAR and ToF measurement systems for distance calculations or object detection.

The input signals to ADC 200, as shown in Figure 2, may include differential signals composed of two complementary components Vₚ and Vₙ. These two signal components may be characterized by opposite polarities. For instance, Vₚ may represent the positive component and Vₙ may represent the corresponding negative component of the differential input. In some examples, these signals may be derived from a single-ended signal that has been converted into a differential form by preceding circuitry. such as a single-ended-to-differential amplifier (e.g., amplifier 103 of Figure 1). The differential input signals Vₚ and Vₙ may vary oppositely around a common-mode voltage V_{CM}. The differential nature of the input signals helps in maximizing SNR and improves noise immunity, as any common-mode noise that may affect both signals equally can be effectively canceled out.

In some embodiments, the output signals of ADC 200 may include a digital signal (e.g., D_{out,diff}), which may be associated with a difference between input signals Vₚ and Vₙ. For instance, ADC samples the difference between Vₚ and Vₙ, converting the differential voltage into discrete digital steps that approximate the amplitude of the input signal at each sampling instant. In some examples, the full range of ADC 200 may span from 0 to 2^{B}-1, where B is the bit resolution of the ADC. For instance, the range of an ADC may refer to the maximum and minimum input voltage it can accept. As an example, in an 8-bit ADC, the full digital output range would be from 0 to 255. Ideally, the differential input signals would allow D_{out,diff} to utilize the entire range, maximizing the ADC's effective resolution and precision.

However, due to the unipolar nature of some input signals-such as those produced by photodiodes (e.g., photodiode 101 of Figure 1) that only vary in one direction relative to a baseline voltage-the digital output D_{out,diff} only occupies half of the ADC's full range, as shown in Figure 2. This limited range results in inefficient use of the ADC's dynamic range, effectively reducing the ADC's resolution and SNR. For example, only utilizing half of the ADC's range may result in an approximate 6 dB reduction in SNR, which corresponds to a one-bit loss in effective resolution-meaning that an 8-bit ADC would perform with the effective precision of a 7-bit ADC under these conditions.

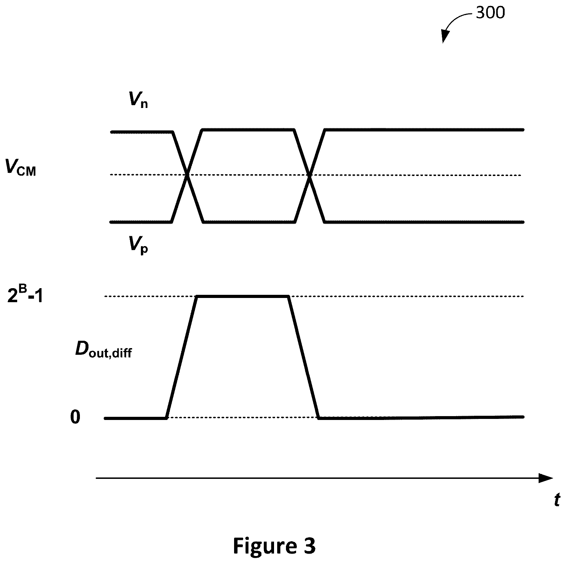

Figure 3 is a schematic diagram illustrating the signal input and output of an analog-to-digital converter (ADC) 300, in accordance with various embodiments of the subject technology. This diagram merely provides an example, which should not unduly limit the scope of the claims. One of ordinary skill in the art would recognize many variations, alternatives, and modifications.

Similar to ADC 200 in Figure 2, ADC 300 may be part of a larger sensor-based or signal-processing system, such as ADC 104 depicted in Figure 1. In these systems, ADC 300 may be used to convert analog signals into digital representations for further analysis, processing, and interpretation. For instance, ADC 300 may be used in applications such as LiDAR and ToF measurement systems for distance calculations or object detection.

The input signals to ADC 300, as shown in Figure 3, may include differential signals composed of two complementary components Vₚ and Vₙ. These two signal components may be characterized by opposite polarities. For instance, Vₚ may represent the positive component and Vₙ may represent the corresponding negative component of the differential input. In some examples, these signals may be derived from a single-ended signal that has been converted into a differential form by preceding circuitry, such as a single-ended-to-differential amplifier (e.g., amplifier 103 of Figure 1). The differential input signals Vₚ and Vₙ may vary oppositely around a common-mode voltage V_{CM}.

In various implementations, an offset may be added to the input signals Vₚ and Vₙ to ensure that ADC 300 utilizes its full dynamic range. For example, the offset may be applied directly at the input of the ADC to maximize the dynamic range without using AC coupling capacitors. As a result, the output signal D_{out,diff} from ADC 300 may span the full digital range from 0 to 2^{B}-1, where B is the bit resolution of the ADC 300.

However, this approach imposes a limitation, as it restricts the use of alternating current (AC) capacitors in the signal path, which are often essential for isolating direct current (DC) drift and noise. It is to be appreciated that AC coupling capacitors play an important role in optimizing ADC buffer stages, as they help to block DC components and stabilize the signal baseline. Without AC coupling, the input signal is directly tied to the offset applied at the ADC input, making it susceptible to DC drift, temperature variations, and other low-frequency interferences that can impact overall signal integrity. By applying an offset directly at the input, this approach forces the signal chain to be DC-coupled, eliminating the ability to use AC coupling to manage DC offsets and other variations in the signal path. This can lead to degraded signal quality over time and increased susceptibility to unwanted DC shifts, which can impact overall system performance and accuracy.

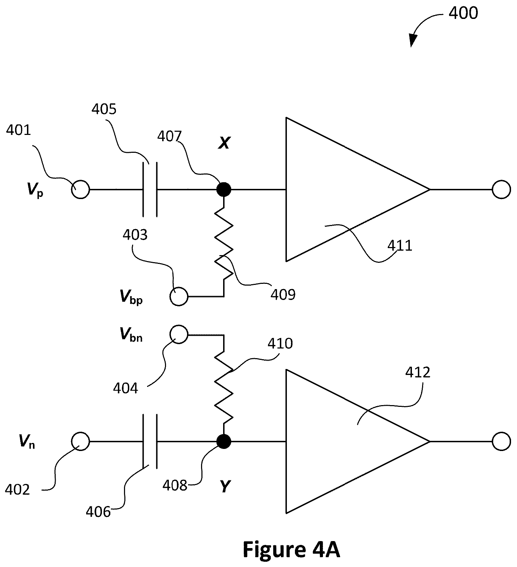

Figure 4A is a schematic diagram illustrating a driver circuit 400 with a bias control mechanism, in accordance with various embodiments of the subject technology. This diagram merely provides an example, which should not unduly limit the scope of the claims. One of ordinary skill in the art would recognize many variations, alternatives, and modifications.

In various implementations, driver circuit 400 may be integrated into an analog-to-digital converter system (e.g., ADC 104 of Figure 1), where it serves as an interface between the input signals and the ADC quantizer stage. For instance, driver circuit 400 may be configured to condition and prepare differential input signals for digitization. Depending on the implementation, driver circuit 400 may adopt a bias control mechanism to ensure that the differential signals presented to the ADC utilize the full input range of the ADC, thereby maximizing SNR and resolution.

In some embodiments, driver circuit 400 may include first terminal 401 and second terminal 402, which may be configured to receive the input signals. For example, the input signal may include a first signal component (e.g., Vₚ). and a second signal component (e.g., Vₙ). First terminal 401 may be configured to receive the first signal component and second terminal may be configured to receive the second signal component. In some cases, these signal components may represent complementary parts of a differential pair, where the first signal component has a positive polarity and the second signal component has a negative polarity.

In various embodiments, driver circuit 400 may include one or more capacitors. For instance, first capacitor 405 may be coupled to first terminal 401. Second capacitor 406 may be coupled to second terminal 406. Examples of capacitors may include, without limitation, ceramic capacitors, electrolytic capacitors, film capacitors, and/or the like. In some examples, capacitors 405 and 406 may be configured to block any DC component in the input signals, allowing only the AC component to pass through. This AC coupling prevents DC offsets from affecting the downstream biasing and amplification stages, maintaining a consistent baseline for the differential signals.

In some implementations, driver circuit 400 may further include third terminal 403 and fourth terminal 404, which are used as part of a bias control mechanism. For instance, separate bias voltages V_{bp} (e.g., a positive bias) and V_{bn} (e.g., a negative bias) may be respectively applied to third terminal 403 and fourth terminal 404, allowing for independent control of the voltage levels for each input signal. These bias voltages may be configured to establish the correct operating range for the differential input signals (e.g., Vₚ and Vₙ), effectively shifting their baseline to optimize the input range for the downstream analog-to-digital conversion. This bias control mechanism provides flexibility to adjust the baseline of the differential signals post-AC coupling, ensuring full ADC range utilization without compromising the benefits of AC coupling.

In some cases, the bias voltages V_{bp} and V_{bn} may be generated by a bias circuit (e.g., circuit 107 of Figure 1), which could provide programmable or adaptive biasing based on specific operating conditions or system requirements. For instance, the bias circuit may be coupled to driver 400 through first node 407 and second node 408. First node 407 may be associated with the first signal component, and second node 408 may be associated with the second signal component. By controlling the bias applied at these nodes, the bias circuit can fine-tune the baseline levels of the differential signal components, ensuring that they are appropriately centered within the ADC's input range. This ensures the differential signals are optimally positioned for digitization while preserving AC-coupling benefits. The bias control mechanism allows driver circuit 400 to align the differential signals within the ADC's input range, maximizing the dynamic range and effective resolution of the ADC.

In some embodiments, driver circuit 400 may further include one or more resistors. For instance, first resistor 409 may be coupled to third terminal 403. Second resistor 410 may be coupled to fourth terminal 404. Examples of resistors may include, without limitation, metal-film resistors, wire-wound resistors, metal-oxide resistors, and/or the like. Resistors 409 and 410 help regulate the current flow from the bias sources, preventing abrupt changes in the signal baseline and minimizing the potential for noise or distortion. In some examples, the bias voltages V_{bp} and V_{bn} may be applied through resistors 409 and 410 to respective signal components Vₚ and Vₙ at first node 407 and second node 408.

In various implementations, driver circuit 400 may further include first amplifier 411 and second amplifier 412. For instance, first amplifier 411 may be coupled to first node 407 and second amplifier 412 may be coupled to second node 408. Amplifiers 411 and 412 may serve to further condition the signals after the bias adjustments have been applied, ensuring that Vₚ and Vₙ are at suitable levels for digitization by the ADC. Depending on the implementation, amplifiers 411 and 412 may provide gain adjustment, impedance matching, or buffering functions to stabilize the signals before they are fed to the ADC's quantizer stage.

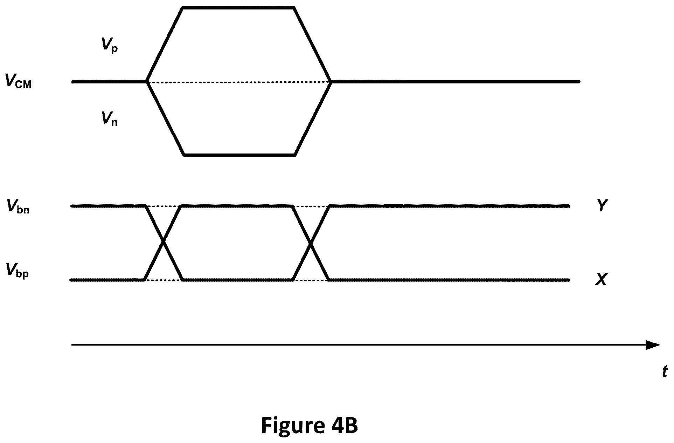

Figure 4B is a schematic diagram illustrating the signal input of an analog-to-digital converter (ADC), in accordance with various embodiments of the subject technology. This diagram merely provides an example, which should not unduly limit the scope of the claims. One of ordinary skill in the art would recognize many variations, alternatives, and modifications. For example, Figure 4B may represent the waveform characteristics of driver circuit 400 of Figure 4A, illustrating how differential input signals Vₚ and Vₙ may be influenced by bias voltages V_{bp} and V_{bn}.

As shown, the signal components Vₚ and Vₙ may be complementary and may vary oppositely around a common-mode voltage V_{CM}. The common-mode voltage V_{CM} may serve as a reference baseline around which the differential signals fluctuate. For instance, Vₚ may represent the positive component of the differential signal, and Vₙ may represent the corresponding negative component. In some examples, Vₚ may be characterized by a first voltage level, and Vₙ may be characterized by a second voltage level.

In various implementations, bias voltages V_{bp} and V_{bn} may be applied to signal components Vₚ and Vₙ, respectively. These bias voltages may be configured to adjust the voltage levels of the signal components Vₚ and Vₙ by shifting the baseline levels of Vₚ and Vₙ relative to V_{CM}, allowing the input signals to utilize the full dynamic range of the ADC. The bias voltages may effectively lift or lower the entire waveform of each signal component. For example, a positive bias voltage (e.g., V_{bp}) applied to the signal component Vₚ may increase the first voltage level by raising the baseline of Vₚ. A negative bias voltage (e.g., V_{bn}) applied to the signal component Vₚ may decrease the second voltage level by lowering the baseline of Vₙ. By introducing these bias voltages, the input signals may be centered around common-mode voltage V_{CM}, allowing the differential input signals to fully utilize the ADC's input range.

Depending on the implementation, the offset may be applied through a bias circuit (e.g., circuit 107 of Figure 1) or other control mechanism within the ADC, which may be configured to adjust the bias voltages of the input signals. In some examples, the offset may be programmable and adaptive, allowing the system to dynamically adjust the bias based on real-time operating conditions or signal characteristics. For instance, a controller (e.g., controller 108 of Figure 1) may monitor the input or output signals and adjust the offset accordingly to maintain optimal signal levels within the ADC's input range.

By fully utilizing the ADC's dynamic range, the output signal captures a more precise digital representation of the input analog signals. improvine the SNR and the effective resolution. The full-range output enables the ADC to detect finer variations in the input signals, which is beneficial for applications that require high precision, such as distance measurements and object detection in LiDAR and ToF systems.

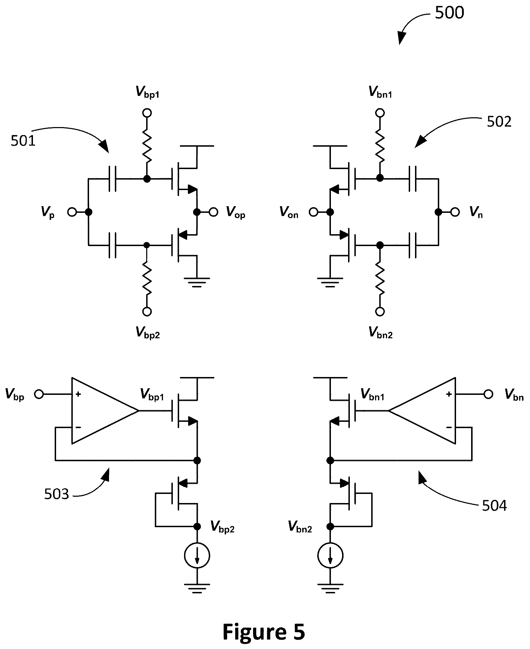

Figure 5 is a schematic diagram illustrating a driver circuit 500 with a bias control mechanism, in accordance with various embodiments of the subject technology. This diagram merely provides an example, which should not unduly limit the scope of the claims. One of ordinary skill in the art would recognize many variations, alternatives, and modifications.

In various implementations, driver circuit 500 may be integrated into an analog-to-digital converter system (e.g., ADC 104 of Figure 1), where it serves as an interface between the input signals and the ADC quantizer stage. For instance, driver circuit 500 may be configured to condition and prepare differential input signals for digitization. Depending on the implementation, driver circuit 500 may adopt a bias control mechanism to ensure that the differential signals presented to the ADC utilize the full input range of the ADC, thereby maximizing SNR and resolution.

In various examples, driver circuit 500 may include first subcircuit 501 and second subcircuit 502, which are configured to provide a controlled differential signal to the ADC. For example, subcircuits 501 and 502 are designed to maintain stability and symmetry between the positive and negative signal paths Vₚ and Vₙ while allowing bias adjustments that maximize the effective dynamic range of the ADC. Each subcircuit may be configured with dedicated bias points (e.g., V_{bp1} and V_{bp2} in subcircuit 501, V_{bn1} and V_{bn2} in subcircuit 502), enabling independent adjustment of the baseline voltage levels for the differential signals.

In some embodiments, driver circuit 500 may include separate bias circuits (e.g., first bias circuit 503 and second bias circuit 504), each of which operates independently to regulate the bias levels for the differential input signals. For example, first bias circuit 503 is associated with the positive signal path Vₚ, and second bias circuit 504 is associated with the negative signal path Vₙ. Bias circuits 503 and 504 may be configured to provide precise and stable control over the baseline voltage levels of their respective signal components, ensuring that the differential signals Vₚ and Vₙ utilize the full input range of the ADC.

In various embodiments, first bias circuit 503 may be configured to receive a first reference voltage (e.g., V_{bp}) and generate a first bias voltage based on the first reference voltage. Second bias circuit 504 may be configured to receive a second reference voltage (e.g., V_{bn}) and generate a second bias voltage based on the second reference voltage. For example, the term "reference voltage" may refer to a stable voltage level used as a standard or baseline to set other voltages in an electronic circuit.

In some examples, reference voltages (e.g., V_{bp} and V_{bn}) may act as control points that determine the bias voltages applied to the differential signal paths. By adjusting the reference voltages, the system can control the offset added to the differential signals. For example, the offset can be disabled by setting both reference voltages to the same value (e.g., V_{bp} = V_{bn}). A negative offset can be applied by setting V_{bp} lower than V_{dn} (e.g., V_{bp} < V_{bn}), while a positive offset can be introduced by setting V_{bp} higher than V_{bn} (e.g., Vbp > Vbn). This configuration enables the system to dynamically adjust the voltage levels of signal components based on specific operating conditions or application requirements, maximizing the effective use of the ADC's input range.

The independent operation of bias circuits 503 and 504 allows for fine-tuned adjustment of each signal component independently, enabling flexible and precise control over the differential signal characteristics. Additionally, by allowing independent control, the system can adapt quickly to changing input conditions or application-specific requirements, thus providing greater stability and improved performance across a wide range of operating environments.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus comprising:
a driver configured to receive an input signal, the input signal comprising a first signal component and a second signal component, the first signal component being **characterized by** a first voltage level and a first polarity, the second signal component being **characterized by** a second voltage level and a second polarity, the first polarity being opposite the second polarity;
a first circuit coupled to the driver, the first circuit being configured to adjust a first voltage level by applying a first bias voltage to the first signal component and adjust a second voltage level by applying a second bias voltage to the second signal component; and
a quantizer coupled to the driver, the quantizer being configured to generate an output signal based at least on the first voltage level and the second voltage level.

2. The apparatus of claim 1, further comprising
a controller coupled to the first circuit, the controller being configured to adjust the first bias voltage and the second bias voltage based at least on the output signal.

3. The apparatus of claim 2, wherein
the controller is configured to store a plurality of bias voltage profiles comprising the first bias voltage and the second bias voltage.

4. The apparatus of any one of the claims 1 to 3, wherein
the first circuit is further configured to calibrate the first bias voltage and the second bias voltage based on a reference signal.

5. The apparatus of any one of the claims 1 to 4, wherein
the first circuit is coupled to the driver through a first node and a second node,
the first node is associated with the first signal component, and
the second node is associated with the second signal component.

6. The apparatus of any one of the claims 1 to 5, wherein
the quantizer comprises a sampling circuit configured to sample the input signal based on a predetermined interval.

7. The apparatus of any one of the claims 1 to 6, wherein
the first circuit comprises a second circuit configured to receive a first reference voltage and generate the first bias voltage based on the first reference voltage.

8. The apparatus of claim 7, wherein
the first circuit comprises a third circuit configured to receive a second reference voltage and generate the second bias voltage based on the second reference voltage.

9. The apparatus of any one of the claims 1 to 8, wherein
the output signal is associated with a difference between the first voltage level and the second voltage level.

10. The apparatus of any one of the claims 1 to 9, wherein
the output signal comprises a digital signal.

11. The apparatus of any one of the claims 1 to 10, wherein
the first bias voltage is configured to increase the first voltage level and/or the second bias voltage is configured to decrease the second voltage level.

12. An apparatus comprising:
a driver configured to receive an input signal, the input signal comprising a first signal component and a second signal component, the first signal component being **characterized by** a first voltage level, the second signal component being **characterized by** a second voltage level;
a first circuit coupled to the driver, the first circuit being configured to adjust a first voltage level by applying a first bias voltage to the first signal component and adjust a second voltage level by applying a second bias voltage to the second signal component; and
a quantizer coupled to the driver, the quantizer being configured to generate an output signal based at least on the first voltage level and the second voltage level.

13. The apparatus of claim 12, further comprising at the one of the following features:
(A) the apparatus further comprises a controller coupled to the first circuit, the controller being configured to adjust the first bias voltage and the second bias voltage based at least on the output signal;
(B) the first bias voltage is configured to increase the first voltage level;
(C) the second bias voltage is configured to decrease the second voltage level;
(D) the first circuit is coupled to the driver through a first node and a second node, the first node is associated with the first signal component, and the second node is associated with the second signal component; and
(E) the output signal is associated with a difference between the first voltage level and the second voltage level.

14. An apparatus comprising:
a driver configured to receive an input signal, the input signal comprising a first signal component and a second signal component, the first signal component being **characterized by** a first voltage level, the second signal component being **characterized by** a second voltage level;
a first circuit coupled to the driver, the first circuit comprising a second circuit configured to generate a first bias voltage and a third circuit configured to generate a second bias voltage, the first circuit being configured to adjust the first voltage level by applying the first bias voltage to the first signal component and adjust the second voltage level by applying the second bias voltage to the second signal component; and
a quantizer coupled to the driver, the quantizer being configured to generate an output signal based at least on the first voltage level and the second voltage level.

15. The apparatus of claim 14, further comprising at least one of the following features:
(A) the apparatus further comprises a controller coupled to the first circuit, the controller being configured to adjust the first bias voltage and the second bias voltage based at least on the output signal; and
(B) the output signal is associated with a difference between the first voltage level and the second voltage level.
